# EUROPEAN PATENT APPLICATION

(11) **EP 4 411 570 A1**
(43) Date of publication of application: **07.08.2024**
(21) Application number: 22888834.3
(22) Date of filing: 08.06.2022
(51) Int. Cl.: G06F 18/00, G06F 7/04

(54) **SIMILARITY CALCULATION APPARATUS AND METHOD, AND MEMORY DEVICE**

(30) Priority: 02.11.2021 CN 202111290869
(71) Applicant: Huawei Technologies Co., Ltd., Shenzhen, Guangdong 518129 (CN)
(72) Inventor: CHENG, Long, Shenzhen, Guangdong 518129 (CN); YANG, Ling, Wuhan, Hubei 430074 (CN); LI, Yi, Wuhan, Hubei 430074 (CN); TAN, Haibo, Shenzhen, Guangdong 518129 (CN); PU, Guiyou, Shenzhen, Guangdong 518129 (CN)
(74) Representative: Epping - Hermann - Fischer
(86) International application number: PCT/CN2022/097665
(87) International publication number: WO 2023/077798

(57) **Abstract**

Embodiments of this application disclose a similarity calculation apparatus and method, and a storage device, and relate to the computer field. A specific solution is as follows: The similarity calculation apparatus includes an input signal processing module, a data calculation module, and at least one output processing circuit that are sequentially coupled, where the data calculation module includes a storage array configured to store to-be-calculated data; the input signal processing module is configured to: generate an operating voltage based on similarity calculation instructions, and convert an address of the to-be-calculated data in the similarity calculation instructions into a target address; the data calculation module is configured to: select, based on the target address, the to-be-calculated data stored in the storage array, and apply the operating voltage to the to-be-calculated data to perform similarity calculation; and the at least one output processing circuit is configured to: process a signal output by the data calculation module, and output a calculation result.

## Description

This application claims priority to Chinese Patent Application No. 202111290869.0, filed with the China National Intellectual Property Administration on November 2, 2021 and entitled "SIMILARITY CALCULATION APPARATUS AND METHOD, AND STORAGE DEVICE", which is incorporated herein by reference in its entirety.

### TECHNICAL FIELD

Embodiments of this application relate to the field of computer technologies, and in particular, to a similarity calculation apparatus and method, and a storage device.

### BACKGROUND

Similarity calculation is generally used for measuring similarity between data objects, and is important and widely used in data analysis. Similarity representation methods and calculation methods vary with different data types. Commonly used similarity representation methods and calculation methods include Hamming distance calculation for a string type, inner product similarity calculation for a vector type, and Jaccard similarity calculation for a set type. Currently, a computing capability of a computer is mainly provided by an operation circuit in a central processing unit (central processing unit, CPU). Because the operation circuit in the CPU does not have a data storage capability, when similarity calculation is performed, to-be-calculated data needs to be loaded from a memory to a CPU cache, a corresponding operation circuit is selected based on different similarity calculation requirements, each group of data pairs are sequentially input to the operation circuit to perform similarity calculation, and a result is written back to the memory after the calculation is completed.

In an existing similarity calculation method, storage (a memory) and computing (a CPU) are separated. This separated data processing mode causes frequent data migration, resulting in high power consumption and a high delay. In addition, when a data amount is very large, a cache miss is easily caused, and performance of a computing device is further deteriorated. In addition, because the operation circuit in the CPU is not configurable, overheads of a circuit area are high when a plurality of types of similarity calculation are implemented.

### SUMMARY

Embodiments of this application provide a similarity calculation apparatus and method, and a storage device, to reduce power consumption and a delay during similarity calculation.

According to a first aspect of embodiments of this application, a similarity calculation apparatus is provided. The similarity calculation apparatus includes an input signal processing module, a data calculation module, and at least one output processing circuit. The input signal processing module is coupled to the at least one output processing circuit via the data calculation module. The data calculation module includes a storage array, and the storage array is configured to store to-be-calculated data. The input signal processing module is configured to: receive similarity calculation instructions, generate an operating voltage based on the similarity calculation instructions, and convert an address of the to-be-calculated data in the similarity calculation instructions into a target address. The data calculation module is configured to: select, based on the target address, the to-be-calculated data stored in the storage array, and apply the operating voltage to the to-be-calculated data to perform similarity calculation. The at least one output processing circuit is configured to: process a signal output by the data calculation module, and output a calculation result.

Based on this solution, the storage array is disposed in the data calculation module, and the operating voltage is applied to the to-be-calculated data stored in the storage array to perform similarity calculation, so that the similarity calculation apparatus can store the data and perform similarity calculation. Therefore, the data does not need to be frequently migrated between a memory and an operation circuit. In comparison with a similarity calculation solution in a current technology, energy consumption of data migration can be reduced, and bandwidth between storage and computing can be saved.

In a possible implementation, the similarity calculation instructions include a similarity calculation type, and the input signal processing module includes a voltage encoding circuit, a first voltage conversion circuit, and an address decoding circuit. The voltage encoding circuit is configured to generate the operating voltage based on the similarity calculation type. The first voltage conversion circuit is configured to: directly transfer the operating voltage generated by the voltage encoding circuit to the data calculation module, or reverse the operating voltage generated by the voltage encoding circuit and then transfer the operating voltage to the data calculation module. The address decoding circuit is configured to convert the address of the to-be-calculated data in the similarity calculation instructions into the target address.

Based on this solution, the operating voltage is generated by the voltage encoding circuit, and is directly transferred or transferred after being reversed by the first voltage conversion circuit based on different similarity calculation types, so that the operating voltage can be applied to the to-be-calculated data stored in the storage array to implement the similarity calculation. In this way, the energy consumption of the data migration is reduced, and the bandwidth between the storage and the computing is saved.

In another possible implementation, the data calculation module further includes a switch array, and the input signal processing module is coupled to the storage array via the switch array. The switch array is configured to: select, based on the target address output by the address decoding circuit, a row and a column corresponding to the target address.

Based on this solution, the switch array sets switches on a row and a column in which a storage unit storing the to-be-calculated data is located to an on state, and sets switches on a row or a column in which another storage unit is located to an off state, so that the operating voltage can be applied to the to-be-calculated data stored in the storage array to implement the similarity calculation. In this way, the energy consumption of the data migration is reduced, and the bandwidth between the storage and the computing is saved.

In still another possible implementation, the at least one output processing circuit includes a first output processing circuit, and the first output processing circuit includes a transimpedance amplification circuit and at least one processing subcircuit. The transimpedance amplification circuit is configured to convert the current signal output by the data calculation module into a voltage signal. The at least one processing subcircuit is configured to process and output an analog signal output by the transimpedance amplification circuit.

Based on this solution, the transimpedance amplification circuit converts the current signal output by the data calculation module into the voltage signal, and the at least one processing subcircuit processes the analog signal output by the transimpedance amplification circuit, so that Hamming distance calculation, exact search, or fuzzy search can be implemented.

In still another possible implementation, the at least one processing subcircuit includes a first processing subcircuit, the first processing subcircuit includes an analog-to-digital conversion circuit, and the transimpedance amplification circuit is coupled to the analog-to-digital conversion circuit. The analog-to-digital conversion circuit is configured to convert the analog signal output by the transimpedance amplification circuit into a digital signal and output the digital signal.

Based on this solution, the transimpedance amplification circuit converts the current signal output by the data calculation module into the voltage signal, and the analog-to-digital conversion circuit converts the analog signal output by the transimpedance amplification circuit into the digital signal, so that a Hamming distance calculation result can be obtained. Optionally, by adjusting a threshold in the analog-to-digital conversion circuit, a quantity of different bits, that is, a multi-bit Hamming distance calculation result, can be determined.

In still another possible implementation, the at least one processing subcircuit further includes a second processing subcircuit, the second processing subcircuit includes a sense amplification circuit and a second voltage conversion circuit, and the transimpedance amplification circuit is coupled to the second voltage conversion circuit via the sense amplification circuit. The sense amplification circuit is configured to compare the voltage signal output by the transimpedance amplification circuit with a reference voltage and output the voltage signal. The second voltage conversion circuit is configured to directly output the signal output by the sense amplification circuit or reverse the signal and then output the signal based on the similarity calculation type. Based on this solution, the transimpedance amplification circuit converts the current signal output by the data calculation module into the voltage signal, and the sense amplification circuit compares the voltage signal output by the transimpedance amplification circuit with the reference voltage. A comparison result is directly output by the second voltage conversion circuit or the second voltage conversion circuit, so that a result of the exact search or the fuzzy search may be obtained.

In still another possible implementation, when the similarity calculation type is the exact search, the second voltage conversion circuit is configured to directly output the signal output by the sense amplification circuit; and when the similarity calculation type is the fuzzy search, the second voltage conversion circuit is configured to reverse the signal output by the sense amplification circuit and then output the signal.

Based on this solution, the second voltage conversion circuit may directly output the output signal of the sense amplification circuit or may reverse the output signal of the sense amplification circuit and then output the output signal, to implement the exact search or the fuzzy search based on different similarity calculation types.

In still another possible implementation, when the first output processing circuit includes a plurality of processing subcircuits, the first output processing circuit further includes a first selector. The first selector is configured to: output, to a corresponding processing subcircuit based on the similarity calculation type in the similarity calculation instructions, the analog signal output by the transimpedance amplification circuit.

Based on this solution, the first output processing circuit includes the plurality of processing subcircuits, and the first selector is disposed, so that the first output processing circuit can be used for the Hamming distance calculation, and can also be used for the exact search and the fuzzy search. In addition, because the plurality of processing subcircuits share the transimpedance amplification circuit, the similarity calculation apparatus provided in this embodiment of this application can implement a plurality of similarity calculation functions by adding only a few circuits. In comparison with the current technology in which a calculation function is unconfigurable, this embodiment of this application has an advantage of low circuit area overheads. In still another possible implementation, the at least one output processing circuit further includes a second output processing circuit, and the second output processing circuit includes an analog-to-digital conversion circuit. The analog-to-digital conversion circuit is configured to convert an analog signal output by the data calculation module into a digital signal and output the signal.

Based on this solution, the analog-to-digital conversion circuit converts the analog signal output by the data calculation module into the digital signal and outputs the signal, so that a calculation result of inner product similarity calculation may be obtained. Optionally, by setting the threshold in the analog-to-digital conversion circuit to a threshold in one-bit inner product similarity calculation, a calculation result of multi-bit inner product similarity calculation may be obtained. In still another possible implementation, the at least one output processing circuit further includes a third output processing circuit, and the third output processing circuit includes a sense amplification circuit. The sense amplification circuit is configured to compare the signal output by the data calculation module with a first reference current and output the signal.

Based on this solution, the sense amplification circuit compares the signal output by the data calculation module with the first reference current, and then outputs the signal, so that a result of inner product similarity screening may be obtained. The inner product similarity screening is another processing of the calculation result of the inner product similarity. The first reference current is set in the sense amplification circuit, and the inner product similarity calculation result is screened, so that an output signal that is successfully matched is "1", and an output signal that fails to be matched is "0".

In still another possible implementation, the at least one output processing circuit further includes a fourth output processing circuit. The fourth output processing circuit includes a sense amplification circuit, a delay circuit, and a division circuit. An output end of the sense amplification circuit is separately coupled to an input end of the delay circuit and a first input end of the division circuit, and an output end of the delay circuit is coupled to a second input end of the division circuit.

Based on this solution, the sense amplification circuit, the delay circuit, and the division circuit are disposed in the fourth output processing circuit, so that Jaccard similarity calculation is implemented.

In still another possible implementation, the sense amplification circuit is configured to: compare a first signal output by the data calculation module in a first clock cycle with a second reference current to obtain a first value, and output the first value to the delay circuit; and compare a second signal output by the data calculation module in a second clock cycle with a third reference current to obtain a second value, and output the second value to the division circuit, where the second reference current is different from the third reference current. The delay circuit is configured to delay the first value output by the sense amplification circuit and then output the first value to the division circuit. The division circuit is configured to perform division operation on the first value and the second value, and output a calculation result.

Based on this solution, because Jaccard similarity indicates a proportion of an intersection element to a union element in two sets, two clock cycles are required for the Jaccard similarity calculation. A first clock cycle is used for calculating an AND (AND) operation between the two sets, and a second clock cycle is used for calculating an OR (OR) operation between the two sets and the division operation between an AND operation result and an OR operation result. Therefore, in this solution, the AND operation and the OR operation can be implemented by setting a value of a reference current in the sense amplification circuit, and the AND operation result and the OR operation result are divided, to obtain a result of the Jaccard similarity calculation.

In still another possible implementation, the third output processing circuit further includes a third selector. The third selector is configured to: directly output the output signal of the sense amplification circuit or output the output signal of the sense amplification circuit to a calculation circuit based on the similarity calculation type in the similarity calculation instructions.

Based on this solution, when inner product similarity screening and Jaccard similarity calculation are performed, the sense amplification circuit may be shared. Based on different similarity calculation types, when the similarity calculation type is the inner product similarity screening, the third selector directly outputs the output signal of the sense amplification circuit; and when the similarity calculation type is the Jaccard similarity calculation, the third selector outputs the output signal of the sense amplification circuit to the calculation circuit. In this solution, the third selector is disposed, so that the first output processing circuit can be used for Hamming distance calculation, and can also be used for the exact search and the fuzzy search. In addition, the sense amplification circuit may be used for the inner product similarity screening, and may also be used for the Jaccard similarity calculation. Therefore, in this solution, the plurality of similarity calculation functions can be implemented by adding only the few circuits. In comparison with the current technology in which the calculation function is unconfigurable, this embodiment of this application has the advantage of the low circuit area overheads.

In still another possible implementation, the calculation circuit includes a delay circuit and a division circuit, an output end of the third selector is separately coupled to an input end of the delay circuit and a first input end of the division circuit, and an output end of the delay circuit is coupled to a second input end of the division circuit. The third selector is specifically configured to: when the similarity calculation type is the Jaccard similarity calculation, output, to the delay circuit, a signal output by the sense amplification circuit in a first clock cycle, and output, to the division circuit, a signal output by the sense amplification circuit in a second clock cycle. The delay circuit is configured to delay the signal output by the sense amplification circuit in the first clock cycle and then output the signal to the division circuit. The division circuit is configured to: perform division operation on the signal output by the sense amplification circuit in the first clock cycle and the signal output by the sense amplification circuit in the second clock cycle, and output a calculation result.

Based on this solution, the sense amplification circuit may be shared when the similarity calculation apparatus performs inner product similarity screening and Jaccard similarity calculation. Therefore, when the plurality of similarity calculation functions are implemented, the circuit area overheads of the similarity calculation apparatus are low, and costs are lower.

In still another possible implementation, when the similarity calculation apparatus includes a plurality of output processing circuits, the similarity calculation apparatus further includes a second selector. The second selector is configured to: output, based on the similarity calculation type in the similarity calculation instructions, the signal output by the data calculation module to a corresponding output processing circuit.

Based on this solution, when there are a plurality of at least one output processing circuits, the second selector is disposed, so that the similarity calculation apparatus may be configured for a plurality of different types of similarity calculation. In addition, the input signal processing module, the data calculation module, and some components in the output processing circuits may be shared for the plurality of different types of similarity calculation. Therefore, in this solution, the plurality of similarity calculation functions can be implemented by adding only the few circuits. In comparison with the current technology in which the calculation function is unconfigurable, this embodiment of this application has the advantage of the low circuit area overheads.

In still another possible implementation, the similarity calculation type includes at least one of the Hamming distance calculation, the fuzzy search, the exact search, the inner product similarity calculation, the inner product similarity screening, or the Jaccard similarity calculation.

Based on this solution, the plurality of similarity calculation functions can be implemented. In comparison with the current technology in which the calculation function is unconfigurable, in this solution, because the input signal processing module, the data calculation module, and the some components in the output processing circuits may be shared for the plurality of different types of similarity calculation, the plurality of similarity calculation functions can be implemented by adding only the few circuits, and this solution has the advantage of the low circuit area overheads. According to a second aspect of embodiments of this application, a similarity calculation method is provided. The method includes: first, generating an operating voltage based on similarity calculation instructions, and converting an address of to-be-calculated data in the similarity calculation instructions into a target address; second, selecting the to-be-calculated data based on the target address, and applying the operating voltage to the to-be-calculated data to perform similarity calculation, to generate an output signal; and finally, processing the output signal and outputting a calculation result.

In a possible implementation, the similarity calculation instructions include a similarity calculation type, and the generating an operating voltage based on similarity calculation instructions includes: generating, based on the similarity calculation type, the operating voltage by using the data in the similarity calculation instructions.

In another possible implementation, the similarity calculation type includes at least one of Hamming distance calculation, fuzzy search, exact search, inner product similarity calculation, or inner product similarity screening.

In still another possible implementation, a similarity calculation type is Jaccard similarity calculation, the output signal includes a first signal output in a first clock cycle and a second signal output in a second clock cycle, and the processing the output signal and outputting a calculation result includes: comparing the first signal with a second reference current to obtain a first value, and outputting the first value after a delay of one clock cycle; first, comparing the second signal with a third reference current to obtain a second value, and directly outputting the second value, where the second reference current is different from the third reference current; and then, performing division operation on the first value and the second value, and outputting the calculation result.

According to a third aspect of embodiments of this application, a storage device is provided. The storage device includes a controller and the similarity calculation apparatus according to the first aspect, and the controller is configured to send similarity calculation instructions to the similarity calculation apparatus.

In a possible implementation, the storage device further includes a storage module, and the storage module is configured to store to-be-calculated data and a calculation result.

In another possible implementation, the storage device is a hard disk or a memory.

For effect descriptions of the implementations of the second aspect and the third aspect, refer to effect descriptions of the corresponding implementations of the first aspect. Details are not described herein again.

### BRIEF DESCRIPTION OF DRAWINGS

FIG. 1 is a schematic diagram of a structure of a similarity calculation apparatus according to an embodiment of this application;
FIG. 2 is a schematic diagram of a structure of another similarity calculation apparatus according to an embodiment of this application;
FIG. 3 is a schematic diagram of a calculation principle of a similarity calculation apparatus according to an embodiment of this application;
FIG. 4 is a schematic diagram of a structure of still another similarity calculation apparatus according to an embodiment of this application;
FIG. 5 is a schematic diagram of a calculation principle of another similarity calculation apparatus according to an embodiment of this application;
FIG. 6 is a schematic diagram of a calculation principle of still another similarity calculation apparatus according to an embodiment of this application;
FIG. 7 is a schematic diagram of a structure of still another similarity calculation apparatus according to an embodiment of this application;
FIG. 8 is a schematic diagram of a structure of still another similarity calculation apparatus according to an embodiment of this application;
FIG. 9 is a schematic diagram of a calculation principle of still another similarity calculation apparatus according to an embodiment of this application;
FIG. 10 is a schematic diagram of a structure of still another similarity calculation apparatus according to an embodiment of this application;
FIG. 11 is a schematic diagram of a structure of still another similarity calculation apparatus according to an embodiment of this application;
FIG. 12 is a schematic diagram of a calculation principle of still another similarity calculation apparatus according to an embodiment of this application;
FIG. 13 is a schematic diagram of a structure of still another similarity calculation apparatus according to an embodiment of this application;
FIG. 14 is a schematic diagram of a structure of still another similarity calculation apparatus according to an embodiment of this application;
FIG. 15 is a schematic diagram of a structure of a storage device according to an embodiment of this application; and
FIG. 16 is a schematic flowchart of a similarity calculation method according to an embodiment of this application.

### DESCRIPTION OF EMBODIMENTS

The following describes the technical solutions in embodiments of this application with reference to the accompanying drawings in embodiments of this application. In this application, "at least one" means one or more, and "a plurality of" means two or more. "And/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. At least one of the following items (pieces) or a similar expression thereof refers to any combination of these items, including any combination of singular items (pieces) or plural items (pieces). For example, at least one (piece) of a, b, or c may represent: a, b, c, a and b, a and c, b and c, or a, b, and c, where a, b, and c may be singular or plural. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity and an execution sequence. For example, "first" in the first output processing circuit and "second" in the second output processing circuit in embodiments of this application are only used for distinguishing between different fault rectification requests. Descriptions such as "first" and "second" in embodiments of this application are merely used for indicating and distinguishing between described objects, do not show a sequence, do not indicate a specific limitation on a quantity of devices in embodiments of this application, and cannot constitute any limitation on embodiments of this application.

It should be noted that, in this application, terms such as "example" or "for example" are used to represent an example, an instance, or an illustration. Any embodiment or design scheme described as "example" or "for example" in this application should not be construed as being more preferred or advantageous than other embodiments or design schemes. To be precise, the words such as "example" or "for example" are intended to present a relative concept in a specific manner. Similarity calculation is used for measuring similarity between data objects, and is important and widely used in data analysis. For example, in the deduplication and compression technology, data blocks need to be compared to determine and delete duplicate data. For another example, in a retrieval system, various types of data such as an input picture, an input text, and input voice are compared with database data, to obtain a query result. For another example, in the graph computing field, comparison and hierarchical clustering need to be performed on massive data to facilitate subsequent intelligent processing. In the similarity calculation, in addition to calculating a similarity result between data, the calculation result may be screened sometimes to obtain original data that meets a requirement. For example, in the retrieval system, after the input data is compared with the database data, the database data that is most similar to the input data is further screened out based on a comparison result.

For different mathematical types of the data, there are different similarity representation methods and calculation methods. Commonly used similarity representation methods and calculation methods include Hamming distance for a string type, inner product similarity for a vector type, and Jaccard similarity for a set type. The following describes concepts of the similarity calculation. Hamming distance: A Hamming distance indicates a quantity of different bits in two equal-length binary strings, and d(x, y) may indicate a Hamming distance between a string x and a string y. A quantity obtained through performing an exclusive OR operation on the strings x and y and counting the quantity of results being 1 is the Hamming distance. For example, the string x is 0101, and the string y is 0011. Because the second and third bits of the string x and the string y are different, the Hamming distance between the string x and the string y is 2. The closer the Hamming distance is to 0, the more similar the two strings are.

Inner product similarity: Inner product similarity indicates a result of accumulating a product of each bit in two equal-length vectors. For example, a vector A = [0, 1, 0, 1], and a vector B = [0, 0, 1, 1]. An inner product of the vector A and the vector B is (0 * 0 + 1 * 0 + 0 * 1 + 1 * 1) = 1. An inner product is often used in cosine similarity calculation to determine a degree of proximity between two vectors in directions. The closer the inner product is to 0, the closer the directions of the two vectors are.

Jaccard similarity: Jaccard similarity indicates a proportion of an intersection element to a union element in two sets. For binary coding, "0" and " 1" may indicate whether an n-dimensional vector has a value in a specific dimension, and then a set of binary numbers with a length of n is formed. For example, a four-dimensional vector A = {0, 1, 0, 1}, and a four-dimensional vector B = {0, 0, 1, 1}. An intersection set of the vector A and the vector B is {0, 0, 0, 1}. To be specific, both the vector A and the vector B have values in a fourth dimension. A union set of the vector A and the vector B is {0, 1, 1, 1}. To be specific, distribution of the vector A and the vector B covers a second dimension, a third dimension, and the fourth dimension. Therefore, Jaccard similarity between the vector A and the vector B is 1/3. The closer the Jaccard similarity is to 1, the more similar the two sets are.

Currently, when a computing device performs similarity calculation, storage and computing are separated. This separated data processing mode causes frequent data migration, resulting in high power consumption and a high delay. In addition, when a data amount is very large, a cache miss is easily caused, and performance of the computing device is further deteriorated. In addition, because an operation circuit in a CPU is not configurable, overheads of a circuit area are high when a plurality of types of similarity calculation are implemented.

To resolve a problem of the high power consumption and the high delay caused by the frequent data migration during the similarity calculation, an embodiment of this application provides a similarity calculation apparatus. The similarity calculation apparatus can store to-be-calculated data and can perform similarity calculation. The data does not need to be frequently migrated between a memory and an operation circuit, so that energy consumption of data migration is reduced and bandwidth between storage and computing is saved. In addition, when the similarity calculation apparatus in this embodiment of this application implements a plurality of different types of similarity calculation, an input signal processing module, a data calculation module, and some components in an output processing circuit may be shared. A plurality of types of similarity calculation functions can be implemented by adding only a few circuits, and overheads of a circuit area are low.

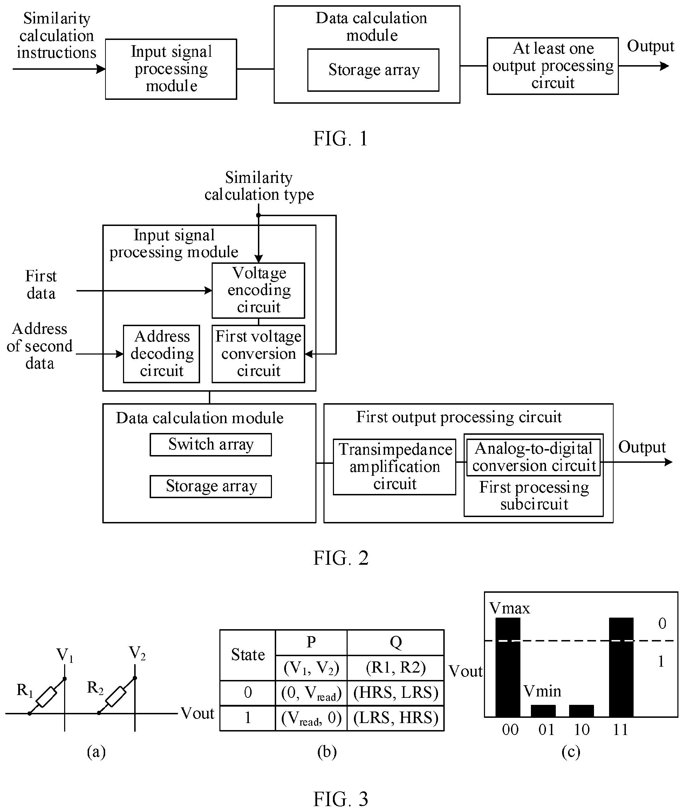

An embodiment of this application provides a similarity calculation apparatus. As shown in FIG. 1, the similarity calculation apparatus includes an input signal processing module, a data calculation module, and at least one output processing circuit. The input signal processing module is coupled to the at least one output processing circuit via the data calculation module. The data calculation module includes a storage array, and the storage array is configured to store to-be-calculated data.

The input signal processing module is configured to: receive similarity calculation instructions, generate an operating voltage based on the similarity calculation instructions, and convert an address of the to-be-calculated data in the similarity calculation instructions into a target address. The similarity calculation instructions are used for calculating similarity between first data and second data. The to-be-calculated data may be the first data and/or the second data. The similarity calculation instructions may include a similarity calculation type. The similarity calculation type includes but is not limited to at least one of Hamming distance calculation, exact search, fuzzy search, inner product similarity calculation, inner product similarity screening, or Jaccard similarity calculation. A specific type of similarity calculation is not limited in this embodiment of this application, and is merely an example for description herein.

When the similarity calculation type is the Hamming distance calculation, the exact search, the fuzzy search, the inner product similarity calculation, or the inner product similarity screening, the similarity calculation instructions may include a value of the first data and an address of the second data, and the storage array in the data calculation module stores the second data. For example, when the similarity calculation instructions indicate to calculate similarity between data P and data Q by using a Hamming distance (or the exact search, or the fuzzy search, or inner product similarity, or the inner product similarity screening), the similarity calculation instructions include a value of the data P and an address of the data Q.

When the similarity calculation type is the Jaccard similarity calculation, the similarity calculation instructions may include an address of the first data and the address of the second data, and the storage array in the data calculation module stores the first data and the second data. For example, when the similarity calculation instructions indicate to calculate the similarity between the data P and the data Q by using Jaccard similarity, the similarity calculation instructions include an address of the data P and the address of the data Q.

With reference to FIG. 1, as shown in FIG. 2, the input signal processing module may include a voltage encoding circuit, a first voltage conversion circuit, and an address decoding circuit.

The voltage encoding circuit is configured to generate the operating voltage based on the similarity calculation type.

The first voltage conversion circuit is configured to: directly transfer the operating voltage generated by the voltage encoding circuit to the data calculation module based on the similarity calculation type, or reverse the operating voltage generated by the voltage encoding circuit and then transfer the operating voltage to the data calculation module.

The address decoding circuit is configured to convert the address of the to-be-calculated data in the similarity calculation instructions into the target address.

For example, when the similarity type is the Hamming distance calculation, the exact search, the inner product similarity calculation, or the inner product similarity screening, the voltage encoding circuit encodes the value of the first data into the operating voltage based on the similarity calculation type, and controls the first voltage conversion circuit to directly transfer the operating voltage. The address decoding circuit converts the address of the second data into the target address. The target address is a corresponding row address and column address in the storage array, and the target address indicates a storage unit in which the second data is located.

For example, when the similarity type is the fuzzy search, the voltage encoding circuit encodes the value of the first data into the operating voltage based on the similarity calculation type, and controls the first voltage conversion circuit to reverse the operating voltage and then transfer the operating voltage. The address decoding circuit converts the address of the second data into the corresponding row address and column address in the storage array.

For example, when the similarity type is the Jaccard similarity calculation, the voltage encoding circuit is configured to: generate the operating voltage, and control the first voltage conversion circuit to directly transfer the operating voltage. The address decoding circuit converts the address of the first data into a first target address, and converts the address of the second data into a second target address. The first target address is the corresponding row address and column address in the storage array in the data calculation module, and the first target address is used for determining a storage unit in which the first data is located. The second target address is the corresponding row address and column address in the storage array in the data calculation module, and the second target address is used for determining the storage unit in which the second data is located.

The data calculation module is configured to: select, based on the target address, the to-be-calculated data stored in the storage array, and apply the operating voltage to the to-be-calculated data to perform similarity calculation.

Optionally, as shown in FIG. 2, the data calculation module may further include a switch array. The input signal processing module is coupled to the storage array via a switch in the switch array, and the storage array is coupled to the at least one output processing circuit via the switch in the switch array. The switch array is configured to: select, based on the target address output by the address decoding circuit, a row and a column corresponding to the target address.

For example, the second data is stored in the storage array, and the second data is the data Q. The address decoding circuit converts the address of the data Q into a row address and column address in the storage array. The switch array sets switches on a row and a column in which a storage unit that stores the data Q is located to an on state, and switches on a row or a column of another storage unit are all set to an off state, so that an operating voltage of the data P can be applied to the data Q to implement the similarity calculation.

The at least one output processing circuit is configured to: process a signal output by the data calculation module, and output a calculation result.

According to the similarity calculation apparatus provided in this embodiment of this application, the storage array is disposed in the data calculation module, and the operating voltage is applied to the to-be-calculated data stored in the storage array to perform similarity calculation. That is, the similarity calculation apparatus in this embodiment of this application can store the data and perform similarity calculation. Therefore, the data does not need to be frequently migrated between a memory and an operation circuit. In comparison with a similarity calculation solution in a current technology, energy consumption of data migration can be reduced, and bandwidth between storage and computing can be saved.

The similarity calculation apparatus provided in this embodiment of this application may implement the plurality of different types of similarity calculation. Based on the different types of similarity calculation, the output processing circuit may include a plurality of different circuit structures. The following describes in detail different circuit structures of the output processing circuit and specific functions of each circuit in the similarity calculation apparatus with reference to different similarity types.

First circuit structure: As shown in FIG. 2, the at least one output processing circuit includes a first output processing circuit, and the first output processing circuit includes a transimpedance amplification circuit and a first processing subcircuit. The first processing subcircuit includes an analog-to-digital conversion circuit, and the transimpedance amplification circuit is coupled to the analog-to-digital conversion circuit.

The transimpedance amplification circuit is configured to convert the current signal output by the data calculation module into a voltage signal.

The analog-to-digital conversion circuit is configured to convert an analog signal output by the transimpedance amplification circuit into a digital signal and output the digital signal.

The foregoing first circuit structure may calculate a Hamming distance between the first data and the second data when the similarity calculation type is the Hamming distance calculation. The following describes specific functions of circuit modules in the similarity calculation apparatus shown in FIG. 2 with reference to FIG. 3.

With reference to FIG. 2, as shown in (a) in FIG. 3, when the similarity calculation instructions indicate to calculate the similarity between the data P and the data Q by using the Hamming distance, two storage units in one row and two columns in the storage array may be selected to represent one piece of data Q. The two storage units may be a primary storage unit R₁ and a secondary storage unit R₂ shown in (a) in FIG. 3. In a coding scheme shown in (b) in FIG. 3, for example, when Q is "0", R₁ is in a high resistance state (high resistance state, HRS), R₂ is in a low resistance state (low resistance state, LRS); and when Q is "1", R₁ is in the low resistance state LRS, and R₂ is in the high resistance state HRS. The voltage encoding circuit may encode the data P into operating voltages V₁ and V₂ applied to the columns in which the two storage units R₁ and R₂ are located. When the data P is "0", the voltage encoding circuit may encode the data P into (0, V_{read}); and when the data P is "1", the voltage encoding circuit may encode the data P into (V_{read}, 0). The first voltage conversion circuit directly transfers the operating voltage output by the voltage encoding circuit to the data calculation module. The address decoding circuit converts the address of the data Q into a corresponding row address and column address in the storage array, to determine the storage unit in which the data Q is located. In the data calculation module, the switch array sets the switches on the row address and the column address of the storage unit in which the data Q is located to the on state, and sets the switches on the row or the column of the another storage unit to the off state, so that the operating voltage of the data P may be applied to the data Q, to implement the Hamming distance calculation.

As shown in (a) in FIG. 3, because a voltage difference between V₁ and V₂ is divided between R₁ and R₂, when the data P and the data Q are different values, different voltage division results Vₒᵤₜ may be obtained. The following describes a specific case of the voltage division result Vₒᵤₜ when the data P and the data Q are different values.

As shown in (c) in FIG. 3, when the data P is 0 and the data Q is also 0, because a voltage of V₁ is 0, a voltage of V₂ is V_{read}, R₁ is in the high resistance state HRS, and R₂ is in the low resistance state LRS, when R₁ and R₂ are connected in series for voltage division, R₁ in the high resistance state HRS has more voltage division, and R₂ in the low resistance state LRS has less voltage division. A voltage of Vₒᵤₜ is a voltage at two ends of R₁. Therefore, the voltage of Vₒᵤₜ is high, and is Vₘₐₓ shown in (c) in FIG. 3.

As shown in (c) in FIG. 3, when the data P is 0 and the data Q is 1, because the voltage of V₁ is 0, the voltage of V₂ is V_{read}, R₁ is in the low resistance state LRS, and R₂ is in the high resistance state HRS, when R₁ and R₂ are connected in series for voltage division, R₂ in the high resistance state HRS has the more voltage division, and R₁ in the low resistance state LRS has the less voltage division. The voltage of Vₒᵤₜ is the voltage at the two ends of R₁. Therefore, the voltage of Vₒᵤₜ is low, and is Vₘᵢₙ shown in (c) in FIG. 3.

As shown in (c) in FIG. 3, when the data P is 1 and the data Q is 0, because the voltage of V₁ is V_{read}, the voltage of V₂ is 0, R₁ is in the high resistance state HRS, and R₂ is in the low resistance state LRS, when R₁ and R₂ are connected in series for voltage division, R₁ in the high resistance state HRS has the more voltage division, and R₂ in the low resistance state LRS has the less voltage division. The voltage of Vₒᵤₜ is the voltage at the two ends of R₂. Therefore, the voltage of Vₒᵤₜ is low, and is Vₘᵢₙ shown in (c) in FIG. 3.

As shown in (c) in FIG. 3, when the data P is 1 and the data Q is 1, because the voltage of V₁ is V_{read}, the voltage of V₂ is 0, R₁ is in the low resistance state LRS, and R₂ is in the high resistance state HRS, when R₁ and R₂ are connected in series for voltage division, R₂ in the high resistance state HRS has the more voltage division, and R₁ in the low resistance state LRS has the less voltage division. The voltage of Vₒᵤₜ is the voltage at the two ends of R₂. Therefore, the voltage of Vₒᵤₜ is high, and is Vₘₐₓ shown in (c) in FIG. 3.

With reference to the first output processing circuit shown in FIG. 2, the transimpedance amplification circuit in FIG. 2 converts the current signal output by the data calculation module into the voltage signal, and then the analog-to-digital conversion circuit converts the analog signal output by the transimpedance amplification circuit into the digital signal, so that a similarity calculation result may be obtained. For example, as shown in (c) in FIG. 3, when the data P and the data Q are the same (for example, P = Q = 0 or P = Q = 1), Vₒᵤₜ is high, and is Vₘₐₓ. When the data P and the data Q are different (for example, P = 0 and Q = 1, or P = 1 and Q = 0), Vₒᵤₜ is low, and is Vₘᵢₙ. Therefore, with reference to a threshold in the analog-to-digital conversion circuit, when the data P and the data Q are different values, Vₒᵤₜ may be set to "0" or "1", so that the Hamming distance calculation is implemented.

FIG. 3 uses one-digit Hamming distance calculation as an example to describe a calculation principle of the similarity calculation apparatus shown in FIG. 2. For multi-digit Hamming distance calculation, storage units in one row and a plurality of columns may be selected to implement the Hamming distance calculation. If each bit is the same, a row voltage is Vₘₐₓ; if each bit is different, the row voltage is Vₘᵢₙ; or if only some bits are the same, the row voltage is a value between Vₘᵢₙ and Vₘₐₓ. By adjusting the threshold in the analog-to-digital conversion circuit, a quantity of different bits, that is, a multi-bit Hamming distance calculation result, can be determined.

For example, that both the first data and the second data are five bits is used an example. When the Hamming distance between the first data and the second data is calculated, storage units in one row and ten columns may be selected from the storage array to represent the second data, and storage units in every two columns in the one row and ten columns represent a value of one bit in the second data. When the five bits of the first data and the five bits of the second data are the same, the output voltage Vₒᵤₜ is high, and is Vₘₐₓ; when each of the five bits of the first data and each of the five bits of the second data is different, the output voltage Vₒᵤₜ is low, and is Vₘᵢₙ; or when four of the five bits of the first data and the five bits of the second data are the same, the output voltage Vₒᵤₜ is between Vₘᵢₙ and Vₘₐₓ. For example, that the output voltage is 0.1 V when one bit of the five bits of the first data and the five bits of the second data are the same is used as an example. When the output voltage Vₒᵤₜ is 0.4 V, it may be determined that four bits of the five digits of the first data and the five digits of the second data are the same, and a Hamming distance calculation result is 4.

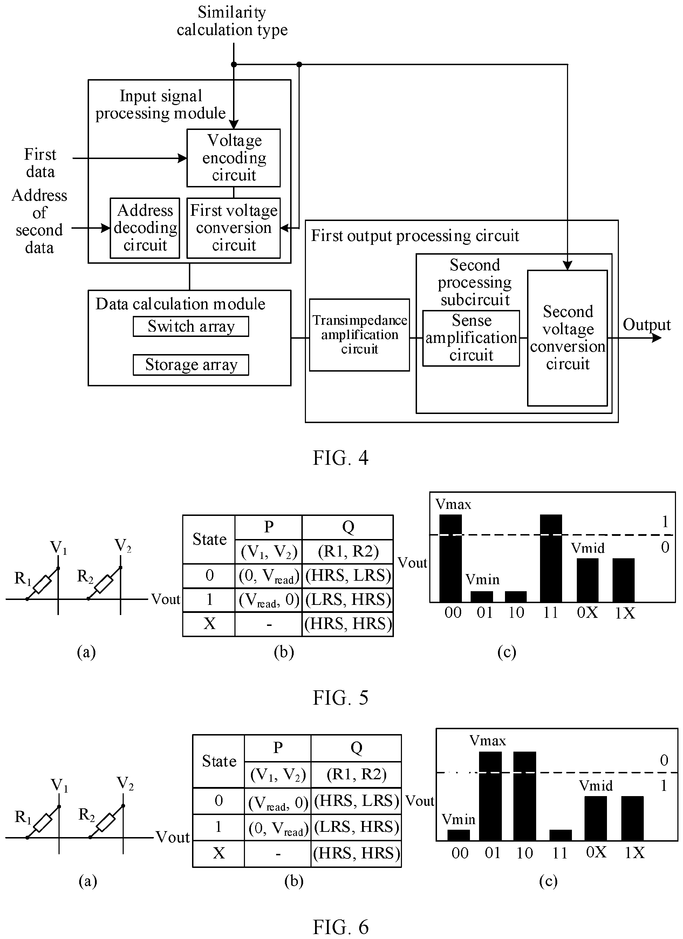

Second circuit structure: As shown in FIG. 4, the at least one output processing circuit includes a first output processing circuit, and the first output processing circuit includes a transimpedance amplification circuit and a second processing subcircuit. The second processing subcircuit includes a sense amplification circuit and a second voltage conversion circuit, and the transimpedance amplification circuit is coupled to the second voltage conversion circuit via the sense amplification circuit.

The transimpedance amplification circuit is configured to convert the current signal output by the data calculation module into the voltage signal.

The sense amplification circuit is configured to compare the voltage signal output by the transimpedance amplification circuit with a reference voltage and output the voltage signal.

The second voltage conversion circuit is configured to: directly output the signal output by the sense amplification circuit or reverse the signal and then output the signal based on a similarity calculation function.

The foregoing second circuit structure may be used to determine the similarity between the first data and the second data when the similarity calculation type is the exact search or the fuzzy search. When the similarity calculation type is the exact search, the first voltage conversion circuit is configured to directly transfer the operating voltage generated by the voltage encoding circuit to the data calculation module, and the second voltage conversion circuit is configured to directly output the signal output by the sense amplification circuit. When the similarity calculation function is the fuzzy search, the first voltage conversion circuit is configured to reverse the operating voltage generated by the voltage encoding circuit and then transfer the operating voltage to the data calculation module, and the second voltage conversion circuit is configured to reverse the signal output by the sense amplification circuit and then output the signal. With reference to FIG. 5 and FIG. 6, the following separately describes specific functions of the similarity calculation apparatus shown in FIG. 4 for implementing the exact search and the fuzzy search.

With reference to FIG. 4, as shown in (a) in FIG. 5, when the similarity calculation instructions indicate the data P to perform the exact search in a search range Q, two storage units in one row and two columns in the storage array may be selected to represent one piece of data Q. The two storage units may be a primary storage unit R₁ and a secondary storage unit R₂ shown in (a) in FIG. 5. Different from the coding scheme shown in (b) in FIG. 3, the exact search adds a coding scheme to data in the search range Q on the basis of the Hamming distance calculation. To be specific, in addition to "0" or "1" that can be determined currently, an "X" state that cannot be determined currently is also included. The "X" state may be used in but not limited to the following scenarios: feature data that cannot be classified currently, data that is not collected currently, and data of different lengths that needs to be supplemented, and the like. As shown in (b) in FIG. 5, the coding scheme of the "X" state of the data Q is that both R₁ and R₂ are in the high resistance state HRS. A coding scheme of the data Q being 0 and 1 and a coding scheme of the data P are the same as those in the Hamming distance calculation, and details are not described herein again. As shown in (b) in FIG. 5, after the voltage encoding circuit encodes the data P as operating voltages V₁ and V₂ applied to the columns in which the two storage units R₁ and R₂ are located, the first voltage conversion circuit directly transfers the operating voltage output by the voltage encoding circuit to the data calculation module. The address decoding circuit converts an address of the search range Q into a corresponding row address and column address in the storage array, to determine the storage unit in which Q is located. In the data calculation module, the switch array sets switches on a row address and a column address of the storage unit in which the data Q is located to the on state, and sets switches on a row or a column of another storage unit to the off state, so that the operating voltage of the data P may be applied to the data Q, and the exact search is performed on the data P in the search range Q.

As shown in (a) in FIG. 5, because a voltage difference between V₁ and V₂ is divided between R₁ and R₂, when the data P and the data Q are different values, different voltage division results Vₒᵤₜ may be obtained. The following describes a specific case of the voltage division result Vₒᵤₜ when the data P and the data Q are different values.

As shown in (c) in FIG. 5, when the data P is 0 and the search range Q is also 0, because the voltage of V₁ is 0, the voltage of Vz is V_{read}, R₁ is in the high resistance state HRS, and R₂ is in the low resistance state LRS, when R₁ and R₂ are connected in series for voltage division, R₁ in the high resistance state HRS has more voltage division, and R₂ in the low resistance state LRS has less voltage division. A voltage of Vₒᵤₜ is a voltage at two ends of R₁. Therefore, the voltage of Vₒᵤₜ is high, and is Vₘₐₓ shown in (c) in FIG. 5.

As shown in (c) in FIG. 5, when the data P is 0 and the search range Q is 1, because the voltage of V₁ is 0, the voltage of V₂ is V_{read}, R₁ is in the low resistance state LRS, and R₂ is in the high resistance state HRS, when R₁ and R₂ are connected in series for voltage division, R₂ in the high resistance state HRS has the more voltage division, and R₁ in the low resistance state LRS has the less voltage division. The voltage of Vₒᵤₜ is the voltage at the two ends of R₁. Therefore, the voltage of Vₒᵤₜ is low, and is Vₘᵢₙ shown in (c) in FIG. 5.

As shown in (c) in FIG. 5, when the data P is 1 and the search range Q is 0, because the voltage of V₁ is V_{read}, the voltage of V₂ is 0, R₁ is in the high resistance state HRS, and R₂ is in the low resistance state LRS, when R₁ and R₂ are connected in series for voltage division, R₁ in the high resistance state HRS has the more voltage division, and R₂ in the low resistance state LRS has the less voltage division. The voltage of Vₒᵤₜ is the voltage at the two ends of R₂. Therefore, the voltage of Vₒᵤₜ is low, and is Vₘᵢₙ shown in (c) in FIG. 3.

As shown in (c) in FIG. 5, when the data P is 1 and the search range Q is 1, because the voltage of V₁ is V_{read}, the voltage of V₂ is 0, R₁ is in the low resistance state LRS, and R₂ is in the high resistance state HRS, when R₁ and R₂ are connected in series for voltage division, R₂ in the high resistance state HRS has the more voltage division, and R₁ in the low resistance state LRS has the less voltage division. The voltage of Vₒᵤₜ is the voltage at the two ends of R₂. Therefore, the voltage of Vₒᵤₜ is high, and is Vₘₐₓ shown in (c) in FIG. 5.

As shown in (c) in FIG. 5, when the data P is 0 and the search range Q is X, because the voltage of V₁ is 0, the voltage of V₂ is V_{read}, both R₁ and R₂ are in the high resistance state LRS, and when R₁ and R₂ are connected in series for voltage division, the voltage of Vₒᵤₜ is the voltage at the two ends of R₁. Therefore, a voltage V_{mid} of Vₒᵤₜ is between Vₘᵢₙ and Vₘₐₓ.

As shown in (c) in FIG. 5, when the data P is 1 and the search range Q is X, because the voltage of V₁ is V_{read}, the voltage of V₂ is 0, both R₁ and R₂ are in the high resistance state LRS, and when R₁ and R₂ are connected in series for voltage division, the voltage of Vₒᵤₜ is the voltage at the two ends of R₂. Therefore, the voltage V_{mid} of Vₒᵤₜ is between Vₘᵢₙ and Vₘₐₓ.

With reference to the first output processing circuit shown in FIG. 4, the transimpedance amplification circuit in FIG. 4 converts the current signal output by the data calculation module into the voltage signal, and the sense amplification circuit compares the voltage output by the transimpedance amplification circuit with a preset reference voltage, and amplifies a differential voltage between the voltage output by the transimpedance amplification circuit and the preset reference voltage into a standard voltage signal. The second voltage conversion circuit directly outputs, based on the exact search, the standard voltage signal output by the sense amplification circuit. For example, as shown in (c) in FIG. 5, when the data P and the data Q are the same (for example, P = Q = 0 or P = Q = 1), Vₒᵤₜ is high, and is Vₘₐₓ. When the data P and the data Q are different (for example, P = 0 and Q = 1, or P = 1 and Q = 0, or P = 0 and Q = X, or P = 1 and Q = X), Vₒᵤₜ is low, and is Vₘᵢₙ or V_{mid}. Therefore, by setting the reference voltage in the sense amplification circuit to a value greater than V_{mid} and less than Vₘₐₓ, when the data P and the data Q are different, a standard voltage signal 0 may be output; or when the data P and the data Q are the same, a standard voltage signal 1 may be output, to implement the exact search.

It may be understood that the exact search is another processing of the Hamming distance calculation result. The reference voltage is set in the sense amplification circuit in the first output processing circuit, so that the Hamming distance calculation result can be screened. In this way, an output signal that is successfully matched is "1", and an output signal that fails to be matched is "0".

Different from the exact search, during the fuzzy search, the first voltage conversion circuit in FIG. 4 is configured to reverse the operating voltage generated by the voltage encoding circuit and then transfer the operating voltage to the data calculation module, and the second voltage conversion circuit is configured to reverse the signal output by the sense amplification circuit and then output the signal.

With reference to FIG. 4, as shown in (a) in FIG. 6, when the similarity calculation instructions indicate the data P to perform the fuzzy search in the search range Q, two storage units in one row and two columns in the storage array may be selected to represent one piece of data Q. The two storage units may be a primary storage unit R₁ and a secondary storage unit R₂ shown in (a) in FIG. 6. As shown in (b) in FIG. 6, after the voltage encoding circuit encodes the data P as operating voltages V₁ and V₂ applied to the columns in which the two storage units R₁ and R₂ are located, the first voltage conversion circuit reverses the operating voltage output by the voltage encoding circuit and then transfers the operating voltage to the data calculation module. Therefore, when the data P is "0", the voltage encoding circuit may encode the data P as (0, V_{read}), and after being reversed by the first voltage conversion circuit, the operating voltage of the data P changes to (V_{read}, 0); or when the data P is "1", the voltage encoding circuit may encode the data P as (V_{read}, 0), and after being reversed by the first voltage conversion circuit, the operating voltage of the data P changes to (0, V_{read}). The address decoding circuit converts an address of the search range Q into a corresponding row address and column address in the storage array, to determine a storage unit in which Q is located. In the data calculation module, the switch array sets switches on the row address and the column address of the storage unit in which the data Q is located to the on state, and sets switches on a row or a column of another storage unit to the off state, so that the operating voltage of the data P obtained through reversion may be applied to the data Q, and the fuzzy search is performed on the data P in the search range Q.

As shown in (a) in FIG. 6, because a voltage difference between V₁ and V₂ is divided between R₁ and R₂, when the data P and the data Q are different values, different voltage division results Vₒᵤₜ may be obtained. The following describes a specific case of the voltage division result Vₒᵤₜ when the data P and the data Q are different values.

As shown in (c) in FIG. 6, when the data P is 0 and the search range Q is also 0, because a voltage of V₁ is V_{read}, a voltage of V₂ is 0, R₁ is in the high resistance state HRS, and R₂ is in the low resistance state LRS, when R₁ and R₂ are connected in series for voltage division, R₁ in the high resistance state HRS has the more voltage division, and R₂ in the low resistance state LRS has the less voltage division. A voltage of Vₒᵤₜ is a voltage at two ends of R₂. Therefore, the voltage of Vₒᵤₜ is low, and is Vₘᵢₙ shown in (c) in FIG. 6.

As shown in (c) in FIG. 6, when the data P is 0 and the search range Q is 1, because the voltage of V₁ is V_{read}, the voltage of V₂ is 0, R₁ is in the low resistance state LRS, and R₂ is in the high resistance state HRS, when R₁ and R₂ are connected in series for voltage division, R₂ in the high resistance state HRS has the more voltage division, and R₁ in the low resistance state LRS has the less voltage division. The voltage of Vₒᵤₜ is the voltage at the two ends of R₂. Therefore, the voltage of Vₒᵤₜ is high, and is Vₘₐₓ shown in (c) in FIG. 6.

As shown in (c) in FIG. 6, when the data P is 1 and the search range Q is 0, because the voltage of V₁ is 0, the voltage of V₂ is V_{read}, R₁ is in the high resistance state HRS, and R₂ is in the low resistance state LRS, when R₁ and R₂ are connected in series for voltage division, R₁ in the high resistance state HRS has the more voltage division, and R₂ in the low resistance state LRS has the less voltage division. The voltage of Vₒᵤₜ is the voltage at the two ends of R₁. Therefore, the voltage of Vₒᵤₜ is high, and is Vₘₐₓ shown in (c) in FIG. 6.

As shown in (c) in FIG. 6, when the data P is 1 and the search range Q is 1, because the voltage of V₁ is 0, the voltage of V₂ is V_{read}, R₁ is in the low resistance state LRS, and R₂ is in the high resistance state HRS, when R₁ and R₂ are connected in series for voltage division, R₂ in the high resistance state HRS has the more voltage division, and R₁ in the low resistance state LRS has the less voltage division. The voltage of Vₒᵤₜ is the voltage at the two ends of R₁. Therefore, the voltage of Vₒᵤₜ is low, and is Vₘᵢₙ shown in (c) in FIG. 6.

As shown in (c) in FIG. 6, when the data P is 0 and the search range Q is X, because the voltage of V₁ is V_{read}, the voltage of V₂ is 0, both R₁ and R₂ are in the high resistance state LRS, and when R₁ and R₂ are connected in series for voltage division, the voltage of Vₒᵤₜ is the voltage at the two ends of R₂. Therefore, a voltage V_{mid} of Vₒᵤₜ is between Vₘᵢₙ and Vₘₐₓ.

As shown in (c) in FIG. 6, when the data P is 1 and the search range Q is X, because the voltage of V₁ is 0, the voltage of V₂ is V_{read}, both R₁ and R₂ are in the high resistance state LRS, and when R₁ and R₂ are connected in series for voltage division, the voltage of Vₒᵤₜ is the voltage at the two ends of R₁. Therefore, the voltage V_{mid} of Vₒᵤₜ is between Vₘᵢₙ and Vₘₐₓ.

With reference to the first output processing circuit shown in FIG. 4, the transimpedance amplification circuit in FIG. 4 converts the current signal output by the data calculation module into the voltage signal, and the sense amplification circuit compares the voltage output by the transimpedance amplification circuit with a preset reference voltage, and amplifies the differential voltage between the voltage output by the transimpedance amplification circuit and the preset reference voltage into the standard voltage signal. The second voltage conversion circuit reverses, based on the fuzzy search, the standard voltage signal output by the sense amplification circuit and then outputs the standard voltage signal.

For example, as shown in (c) in FIG. 6, when the data P and the data Q are the same (for example, P = Q = 0, or P = Q = 1, or P = 0 and Q = X, or P = 1 and Q = X), Vₒᵤₜ is Vₘᵢₙ or V_{mid}. When the data P and the data Q are different (for example, P = 0 and Q = 1, or P = 1 and Q = 0), Vₒᵤₜ is Vₘₐₓ. Therefore, by setting the reference voltage in the sense amplification circuit to a value greater than V_{mid} and less than Vₘₐₓ, when the data P and the data Q are the same, Vₒᵤₜ is less than the reference voltage, the sense amplification circuit outputs a standard voltage signal 0, and the second voltage conversion circuit reverses the signal output by the sense amplification circuit and outputs 1. That is, when the data P and the data Q are the same, the standard voltage signal 1 is output. When the data P and the data Q are different, and Vₒᵤₜ is higher than the reference voltage, the sense amplification circuit outputs the standard voltage signal 1, and the second voltage conversion circuit reverses the signal output by the sense amplification circuit and outputs 0. That is, when the data P and the data Q are different, the standard voltage signal 0 is output, so that the exact search can be implemented.

It may be understood that, with reference to FIG. 5 and FIG. 6, it can be learned that when the similarity calculation apparatus shown in FIG. 4 is used for the exact search, if P = 0 and Q = X, or P = 1 and Q = X, it may be determined that the data P and the data Q are different. When the similarity calculation apparatus shown in FIG. 4 is used for the fuzzy search, if P = 0 and Q = X, or P = 1 and Q = X, it may be determined that the data P and the data Q are the same. Optionally, when the first output processing circuit includes a plurality of processing subcircuits, the first output processing circuit further includes a first selector. The first selector is configured to: output, to a corresponding processing subcircuit based on the similarity calculation type in the similarity calculation instructions, the analog signal output by the transimpedance amplification circuit.

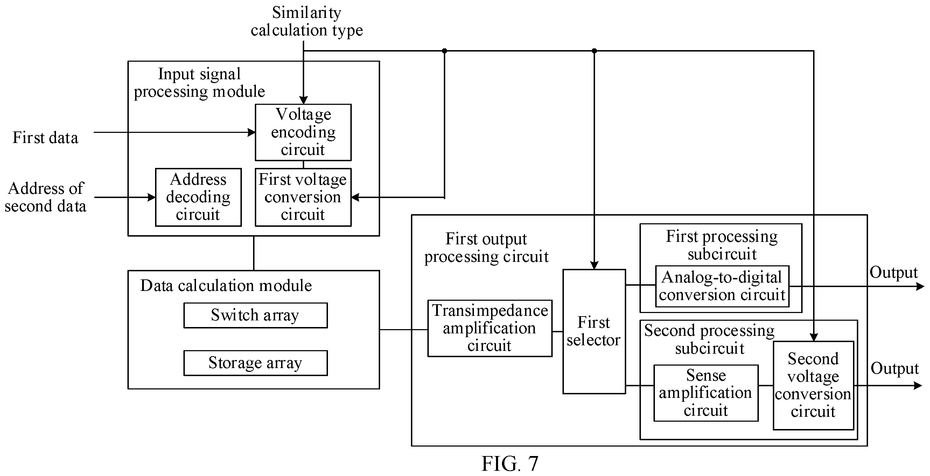

For example, as shown in FIG. 7, an example in which the first output processing circuit includes a first processing subcircuit and a second processing subcircuit is used. When the similarity calculation type is the Hamming distance calculation, the first selector outputs, to the first processing subcircuit, the analog signal output by the transimpedance amplification circuit. When the similarity calculation type is the fuzzy search or the exact search, the first selector outputs, to the second processing subcircuit, the analog signal output by the transimpedance amplification circuit.

It may be understood that the first output processing circuit includes the plurality of processing subcircuits, and the first selector is disposed, so that the first output processing circuit can be used for Hamming distance calculation, and can also be used for the exact search and the fuzzy search. In addition, because the plurality of processing subcircuits share the transimpedance amplification circuit, the similarity calculation apparatus provided in this embodiment of this application can implement a plurality of similarity calculation functions by adding only a few circuits. In comparison with a current technology in which a calculation function is unconfigurable, this embodiment of this application has an advantage of low circuit area overheads.

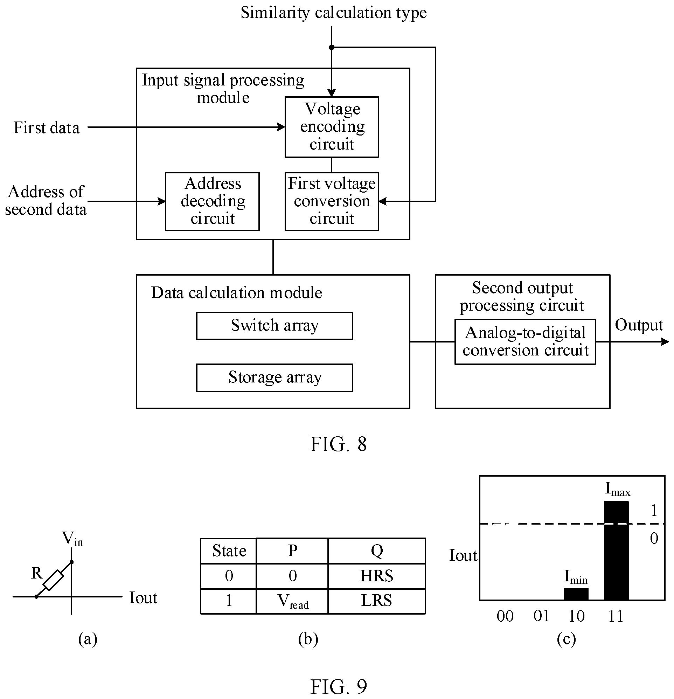

Third circuit structure: As shown in FIG. 8, the at least one output processing circuit may include a second output processing circuit, and the second output processing circuit includes an analog-to-digital conversion circuit.

The analog-to-digital conversion circuit is configured to convert an analog signal output by the data calculation module into a digital signal and output the digital signal.

The foregoing third circuit structure may be used to calculate inner product similarity between the first data and the second data when the similarity calculation type is the inner product similarity calculation. The following describes specific functions of circuit modules in the similarity calculation apparatus shown in FIG. 9 with reference to FIG. 8.

With reference to FIG. 8, as shown in (a) in FIG. 9, when the similarity calculation instructions indicate to calculate the similarity between the data P and the data Q by using the inner product similarity, a storage unit in the storage array may be selected to store the data Q. The storage unit may be the storage unit R shown in (a) in FIG. 9. In a coding scheme shown in (b) in FIG. 9, for example, when Q is "0", R is in a high resistance state HRS; or when Q is "1", R is in a low resistance state LRS. The voltage encoding circuit may encode the data P as an operating voltage Vᵢₙ applied to a column in which a storage unit R is located. When the data P is "0", the voltage encoding circuit may encode the data P as an operating voltage 0. When the data P is "1", the voltage encoding circuit may encode the data P as an operating voltage V_{read}. The first voltage conversion circuit directly transfers the operating voltage output by the voltage encoding circuit to the data calculation module. The address decoding circuit converts the address of the data Q into a corresponding row address and column address in the storage array, to determine the storage unit in which the data Q is located. In the data calculation module, the switch array sets switches on the row address and the column address of the storage unit in which the data Q is located to the on state, and sets switches on a row or a column of another storage unit to the off state, so that the operating voltage of the data P may be applied to the data Q, and the inner product similarity calculation is implemented.

As shown in (a) in FIG. 9, when the operating voltage Vᵢₙ is different and R is in different resistance states, different output currents Iₒᵤₜ may be obtained. The following describes a specific case of the output current Iₒᵤₜ when the data P and the data Q are different values.

As shown in (c) in FIG. 9, when the data P is 0 and the data Q is also 0, because the operating voltage applied to Vᵢₙ is 0 and R is in the high resistance state HRS, the output current Iₒᵤₜ is 0. As shown in (c) in FIG. 9, when the data P is 0 and the data Q is 1, because the operating voltage applied to Vᵢₙ is 0 and R is in the low resistance state LRS, the output current Iₒᵤₜ is 0.

As shown in (c) in FIG. 9, when the data P is 1 and the data Q is also 0, because the operating voltage applied to Vᵢₙ is V_{read}, and R is in the high resistance state HRS, the output current Iₒᵤₜ is small, and is Iₘᵢₙ.

As shown in (c) in FIG. 9, when the data P is 1 and the data Q is also 1, because the operating voltage applied to Vᵢₙ is V_{read} and R is in the low resistance state LRS, the output current Iₒᵤₜ is large, and is Iₘₐₓ.

With reference to the second output processing circuit shown in FIG. 8, the analog-to-digital conversion circuit in FIG. 8 converts the analog signal output by the data calculation module into the digital signal and outputs the digital signal, so that a similarity calculation result may be obtained.

For example, as shown in (c) in FIG. 9, when the data P is 0, the output current Iₒᵤₜ is 0 regardless of whether the data Q is 0 or 1; when the data P is 1, if the data Q is 0, the output current Iₒᵤₜ is small, and is Iₘᵢₙ; or when the data P is 1, if the data Q is 1, the output current Iₒᵤₜ is large, and is Iₘₐₓ. Therefore, with reference to a threshold in the analog-to-digital conversion circuit, 1 may be output when an inner product of the data P and the data Q is 1, or 0 may be output when the inner product of the data P and the data Q is 0, to implement the inner product similarity calculation.

In FIG. 9, a calculation principle of the similarity calculation apparatus shown in FIG. 8 is described by using one-digit inner product similarity calculation as an example. For multi-digit inner product similarity calculation, a storage unit in one row and a plurality of columns may be selected for calculation. A total current in the row reflects a sum of current results from each bit of the inner product similarity calculation. By setting the threshold in the analog-to-digital conversion circuit as a threshold in the one-digit inner product similarity calculation, a calculation result of the multi-bit inner product similarity calculation can be obtained.

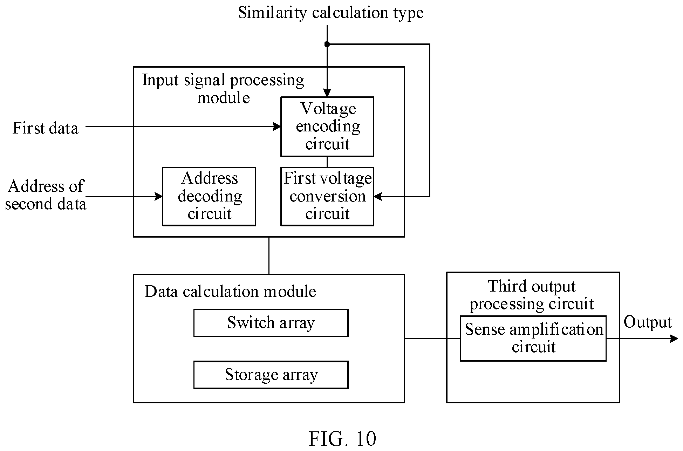

Fourth circuit structure: As shown in FIG. 10, the at least one output processing circuit includes a third output processing circuit, and the third output processing circuit includes a sense amplification circuit. The sense amplification circuit is configured to compare the signal output by the data calculation module with a first reference current and output the signal.

The foregoing fourth circuit structure may be used for screening a calculation result of the inner product similarity when the similarity calculation type is the inner product similarity screening. That is, the inner product similarity screening is another processing of the calculation result of the inner product similarity. The first reference current is set in the sense amplification circuit, and the inner product similarity calculation result is screened, so that an output signal that is successfully matched is "1", and an output signal that fails to be matched is "0".

Functions of each circuit in the input signal processing module and the data calculation module in the similarity calculation apparatus shown in FIG. 10 are the same as those of the similarity calculation apparatus shown in FIG. 8, and details are not described herein again. Different from the similarity calculation apparatus shown in FIG. 8, an output of the analog-to-digital conversion circuit in the second output processing circuit shown in FIG. 8 may be 0, 1, 2, 3, or another value, and a specific output value of the analog-to-digital conversion circuit is related to a quantity of bits of data. For example, when both two equal-length vectors have six bits, an output result of the similarity calculation apparatus shown in FIG. 8 may be any one of 0, 1, 2, 3, 4, 5, and 6. However, the sense amplification circuit in the third output processing circuit shown in FIG. 10 screens the calculation result of the inner product similarity, and compares the similarity calculation result Iₒᵤₜ with the first reference current, so that 1 may be output when Iₒᵤₜ is larger than the first reference current, and 0 may be output when Iₒᵤₜ is smaller than the first reference current.

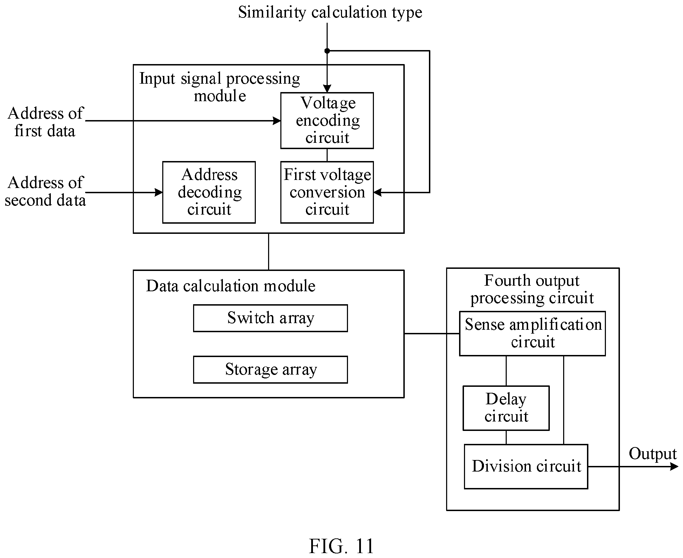

Fifth circuit structure: As shown in FIG. 11, the at least one output processing circuit further includes a fourth output processing circuit, and the fourth output processing circuit includes a sense amplification circuit, a delay circuit, and a division circuit. An output end of the sense amplification circuit is separately coupled to an input end of the delay circuit and a first input end of the division circuit, and an output end of the delay circuit is coupled to a second input end of the division circuit.

The sense amplification circuit is configured to: compare a first signal output by the data calculation module in a first clock cycle with a second reference current to obtain a first value, and output the first value to the delay circuit; and compare a second signal output by the data calculation module in a second clock cycle with a third reference current to obtain a second value, and output the second value to the division circuit. The second reference current is different from the third reference current.

The delay circuit is configured to delay the first value output by the sense amplification circuit and then output the first value to the division circuit.

The division circuit is configured to perform division operation on the first value and the second value, and output a calculation result.

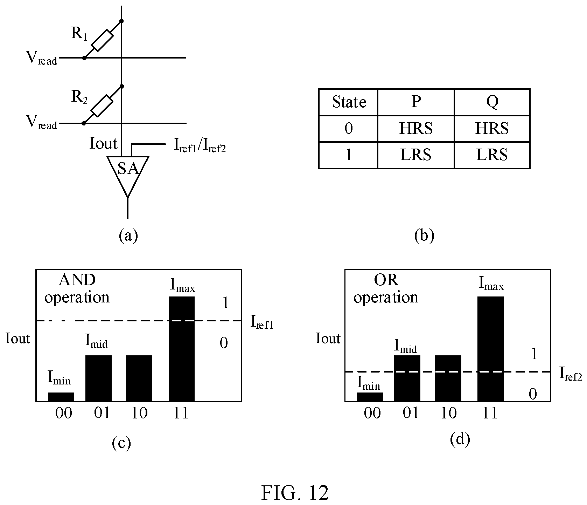

The foregoing fifth circuit structure may be used to calculate the similarity between the first data and the second data when the similarity calculation type is the Jaccard similarity calculation. The following describes specific functions of circuit modules in the similarity calculation apparatus shown in FIG. 11 with reference to FIG. 12.

Because the Jaccard similarity indicates a proportion of an intersection element to a union element in two sets, two clock cycles are required for Jaccard similarity calculation. The first clock cycle is used for calculating an AND (AND) operation between the data P and the data Q, and the second clock cycle is used for calculating an OR (OR) operation between the data P and the data Q and a division operation between an AND operation result and an OR operation result. Whether the AND operation or OR operation is performed in the first clock cycle is not limited in this embodiment of this application. In the following embodiment, an example in which the AND operation is performed in a first clock cycle and the OR operation is performed in a second clock cycle is used for description.

With reference to FIG. 11, when the similarity calculation instructions indicate to calculate the similarity between the data P and the data Q by using the Jaccard similarity, a coding scheme of the data P and the data Q is consistent with that of the storage unit R in the inner product similarity calculation, and one storage unit in the storage array may be separately selected to store the data P and the data Q. As shown in (a) in FIG. 12, two storage units R₁ and R₂ in two rows and one column may be selected to respectively store data P and data Q. As shown in (b) in FIG. 12, for example, when P is "0", R₁ is in a high resistance state HRS, or when P is "1", R₁ is in a low resistance state LRS; and when Q is "0", R₂ is in the high resistance state HRS, or when Q is "1", R₂ is in the low resistance state LRS. The voltage encoding circuit may apply, based on the Jaccard similarity calculation, an operating voltage V_{read} to the rows in which the data P and the data Q are located. The address decoding circuit converts the addresses of the data P and the data Q into corresponding row addresses and column addresses in the storage array, to determine the storage unit in which the data P and the data Q are located. In the data calculation module, the switch array sets switches on the row and column addresses of the storage unit in which the data P and the data Q are located to the on state, and sets switches on rows or columns of another storage unit to the off state, so that after being directly transferred by the first voltage conversion circuit, the operating voltage V_{read} may be applied to the rows in which the data P and the data Q are located. By setting a value of a reference current in the sense amplification circuit, the AND operation can be implemented on the data P and the data Q, the OR operation can be implemented on the data P and data Q, and an AND operation result is divided by an OR operation result, to obtain a calculation result of the Jaccard similarity.

As shown in (a) in FIG. 12, when R₁ and R₂ are in different resistance states, different output currents Iₒᵤₜ may be obtained. The following describes a specific case of the output current Iₒᵤₜ when the data P and the data Q are different values.

As shown in (c) in FIG. 12 and (d) in FIG. 12, when the data P is 0 and the data Q is also 0, both R₁ and R₂ are in the high resistance state HRS. When the operating voltage V_{read} is applied to the rows where R₁ and R₂ are located, because R₁ and R₂ are in the high resistance state, the output current Iₒᵤₜ is small, and is Iₘᵢₙ.

As shown in (c) in FIG. 12 and (d) in FIG. 12, when the data P is 0 and the data Q is 1, R₁ is in the high resistance state HRS, and R₂ is in the low resistance state LRS. When the operating voltage V_{read} is applied to the rows where R₁ and R₂ are located, because R₁ is in the high resistance state and R₂ is in the low resistance state LRS, the output current Iₒᵤₜ is I_{mid}.

As shown in (c) in FIG. 12 and (d) in FIG. 12, when the data P is 1 and the data Q is 0, R₁ is in the low resistance state LRS, and R₂ is in the high resistance state HRS. When the operating voltage V_{read} is applied to the rows where R₁ and R₂ are located, because R₁ is in the low resistance state and R₂ is in the high resistance state, the output current Iₒᵤₜ is I_{mid}.

As shown in (c) in FIG. 12 and (d) in FIG. 12, when the data P is 1 and the data Q is also 1, both R₁ and R₂ are in the low resistance state LRS. When the operating voltage V_{read} is applied to the rows where R₁ and R₂ are located, because R₁ and R₂ are both in the low resistance state, the output current Iₒᵤₜ is large, and is Iₘₐₓ.

With reference to (a) in FIG. 12 and (c) in FIG. 12, if a reference current of a sense amplifier (sense amplifier, SA) is set to I_{ref1} (the second reference current), and I_{ref1} is larger than I_{mid} and less than Iₘₐₓ, because the output current Iₒᵤₜ when P = Q = 0, or P = 0 and Q = 1, or P = 1 and Q = 0 is less than the reference current I_{ref1}, the sense amplifier outputs a standard voltage signal 0 when P = Q = 0, or P = 0 and Q = 1, or P = 1 and Q = 0. When P = Q = 1, the output current Iₒᵤₜ is large and is Iₘₐₓ, and Iₘₐₓ is greater than the reference current I_{ref1}. Therefore, when P = Q = 1, the sense amplifier outputs a standard voltage signal 1. In other words, the reference current of the sense amplifier is set to I_{ref1}, so that the AND operation of the data P and the data Q can be implemented. With reference to (a) in FIG. 12 and (d) in FIG. 12, if the reference current of the sense amplifier SA is set to I_{ref2} (the third reference current), I_{ref2} is larger than Iₘᵢₙ and less than I_{mid}, because the output current Iₒᵤₜ when P = Q = 0 is small and is Iₘᵢₙ, and Iₘᵢₙ is less than the reference current I_{ref2}, the sense amplifier outputs the standard voltage signal 0 when P = Q = 0. When P = 0 and Q = 1, or P = 1 and Q = 0, or P = Q = 1, the output current Iₒᵤₜ is larger than the reference current I_{ref2}. Therefore, when P = 0 and Q = 1, or P = 1 and Q = 0, or P = Q = 1, the sense amplifier outputs the standard voltage signal 1. In other words, the reference current of the sense amplifier is set to I_{ref2}, so that the OR operation on the data P and the data Q can be implemented.

With reference to FIG. 11, the sense amplifier in the fourth output circuit may output the AND operation result in the first clock cycle, and output the AND operation result to the delay circuit. The delay circuit delays the AND operation result for one clock cycle and then outputs the result to the division circuit. The sense amplifier outputs the OR operation result in the second clock cycle, and directly outputs the OR operation result to the division circuit. The division circuit performs division operation on the AND operation result and the OR operation result, to obtain the calculation result of the Jaccard similarity.

Optionally, when the similarity calculation apparatus includes a plurality of output processing circuits, the similarity calculation apparatus further includes a second selector. The plurality of output processing circuits may include at least two output processing circuits of the first output processing circuit, the second output processing circuit, the third output processing circuit, or the fourth output processing circuit.

The second selector is configured to: output, based on the similarity calculation type in the similarity calculation instructions, the signal output by the data calculation module to a corresponding output processing circuit.

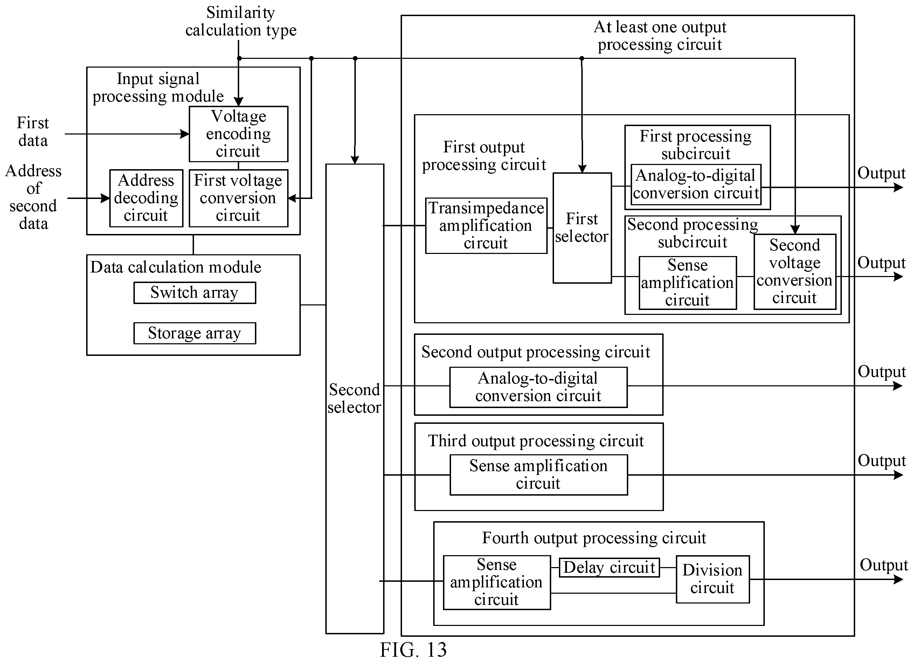

For example, as shown in FIG. 13, an example in which the similarity calculation apparatus includes the first output processing circuit, the second output processing circuit, the third output processing circuit, and the fourth output processing circuit is used. When the similarity calculation type is the Hamming distance calculation, the exact search, or the fuzzy search, the first selector outputs, to the first output processing circuit, the signal output by the data calculation module. When the similarity calculation type is the inner product similarity calculation, the first selector outputs, to the second output processing circuit, the signal output by the data calculation module; when the similarity calculation type is the inner product similarity screening, the first selector outputs, to the third output processing circuit, the signal output by the data calculation module; and when the similarity calculation type is the Jaccard similarity calculation, the first selector outputs, to the fourth output processing circuit, the signal output by the data calculation module. It may be understood that, when there are a plurality of at least one output processing circuits, the second selector is disposed, so that the similarity calculation apparatus may be configured for a plurality of different types of similarity calculation. In addition, the plurality of different types of similarity calculation may share the input signal processing module, the data calculation module, and the some components in the output processing circuit. Therefore, in this solution, a plurality of similarity calculation functions can be implemented by adding only a few circuits. In comparison with the current technology in which a calculation function is unconfigurable, this embodiment of this application has an advantage of low circuit area overheads.

When performing Hamming distance calculation, exact search, fuzzy search, inner product similarity calculation, and inner product similarity screening, the similarity calculation apparatus provided in this embodiment of this application may implement parallel computing between a group of data P and a plurality of groups of data [Q₁, Q₂, Q₃, ...]. When performing Jaccard similarity calculation, parallel computing between two groups of multi-bit data can be implemented. Therefore, in comparison with an existing CPU that performs serial computing in a single core, the similarity calculation apparatus provided in this embodiment of this application can improve a parallelism degree of computing, reduce a computing delay, and improve computing efficiency. In addition, the operating voltage V_{read} is used in the calculation process in this application, and the voltage is a sampling voltage with a very small amplitude. In comparison with a voltage with a high amplitude used in an existing calculation solution, power consumption of the calculation process can be reduced, and a wear burden of a memory can be reduced.

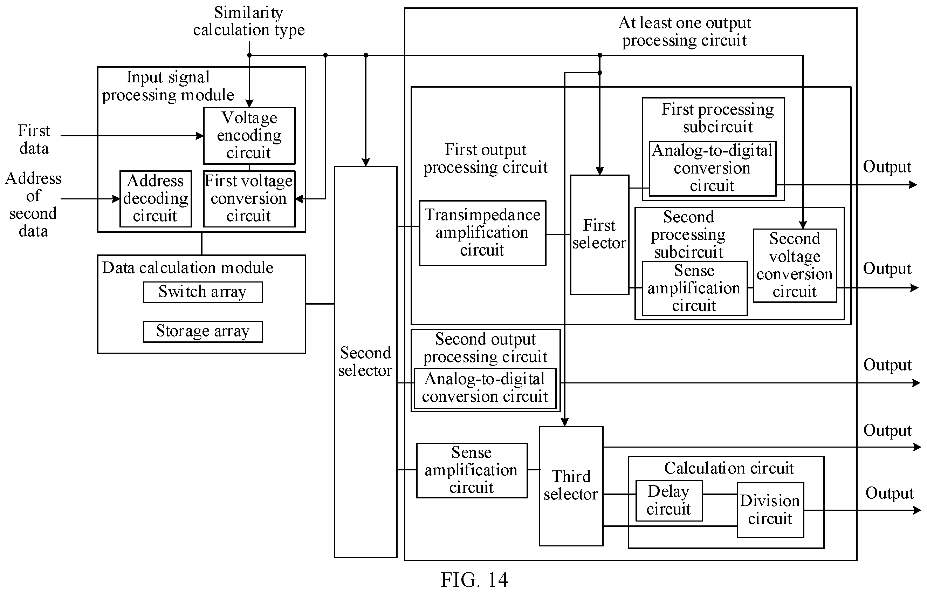

Optionally, the third output processing circuit and the fourth output processing circuit in the similarity calculation apparatus shown in FIG. 13 may share the sense amplification circuit. When the third output processing circuit and the fourth output processing circuit share the sense amplification circuit, this embodiment of this application further provides a similarity calculation apparatus. As shown in FIG. 14, the at least one output processing circuit in the similarity calculation apparatus may further include a third selector. An output end of the sense amplification circuit is coupled to an input end of the third selector. The third selector is configured to: directly output the output signal of the sense amplification circuit or output the signal of the sense amplification circuit to a calculation circuit based on the similarity calculation type.

As shown in FIG. 14, the calculation circuit includes a delay circuit and a division circuit, an output end of the third selector is separately coupled to an input end of the delay circuit and a first input end of the division circuit, and an output end of the delay circuit is coupled to a second input end of the division circuit.

The third selector is specifically configured to: when the similarity calculation type is the Jaccard similarity calculation, output, to the delay circuit, a signal output by the sense amplification circuit in the first clock cycle, and output, to the division circuit, a signal output by the sense amplification circuit in the second clock cycle.

The delay circuit is configured to delay the signal output by the sense amplification circuit in the first clock cycle and then output the signal to the division circuit.

The division circuit is configured to: perform division operation on the signal output by the sense amplification circuit in the first clock cycle and the signal output by the sense amplification circuit in the second clock cycle, and output a calculation result.

For example, as shown in FIG. 14, when the similarity calculation type is the inner product similarity screening, the third selector directly outputs the output signal of the sense amplification circuit. It is equivalent to that an output end of the second selector is coupled to the third output processing circuit.

For another example, as shown in FIG. 14, when the similarity calculation type is the Jaccard similarity calculation, the third selector outputs, to the delay circuit, the signal output by the sense amplification circuit in the first clock cycle, the third selector outputs, to the division circuit, the signal output by the sense amplification circuit in the second clock cycle, and the division circuit performs division operation on the signal output by the sense amplification circuit in the first clock cycle and the signal output by the sense amplification circuit in the second clock cycle, to obtain a calculation result. It is equivalent to that the output end of the second selector is coupled to the fourth output processing circuit.

It may be understood that, compared with the similarity calculation apparatus shown in FIG. 13, the similarity calculation apparatus shown in FIG. 14 may share the sense amplification circuit when performing inner product similarity screening and Jaccard similarity calculation. Therefore, when the plurality of similarity calculation functions are implemented, the similarity calculation apparatus shown in FIG. 14 has lower circuit area overheads and lower costs than the similarity calculation apparatus shown in FIG. 13.

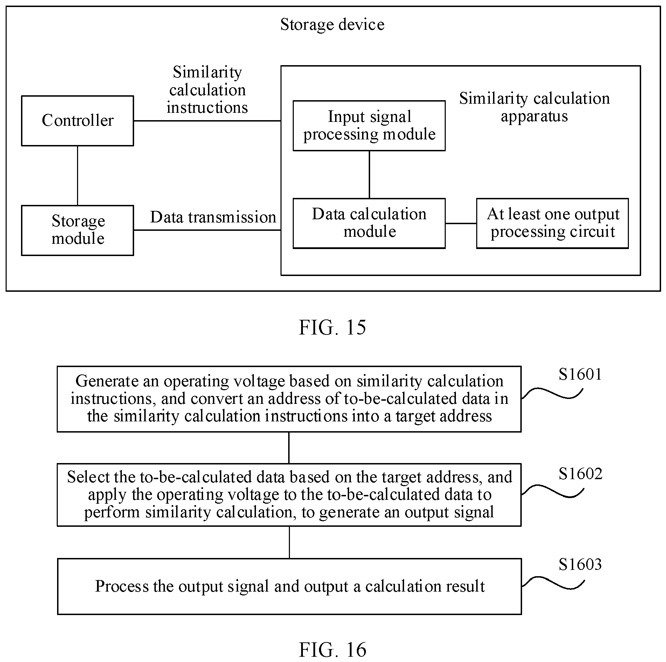

An embodiment of this application further provides a storage device. The storage device may be a hard disk or a memory. As shown in FIG. 15, the storage device includes a controller and the similarity calculation apparatus shown in any one of FIG. 1, FIG. 2, FIG. 4, FIG. 7, FIG. 8, FIG. 10, FIG. 11, FIG. 13, and FIG. 14. The controller is configured to send similarity calculation instructions to the similarity calculation apparatus.

Optionally, as shown in FIG. 15, the storage device may further include a storage module. The storage module is configured to store to-be-calculated data and a calculation result.

An embodiment of this application further provides a similarity calculation method. As shown in FIG. 16, the method includes steps S1601 to S1603.

S1601: Generate an operating voltage based on similarity calculation instructions, and convert an address of to-be-calculated data in the similarity calculation instructions into a target address.

The similarity calculation instructions may include a similarity calculation type, and the similarity calculation type includes at least one of Hamming distance calculation, fuzzy search, exact search, inner product similarity calculation, inner product similarity screening, or Jaccard similarity calculation.

When the similarity calculation type is the Hamming distance calculation, the fuzzy search, the exact search, the inner product similarity calculation, or the inner product similarity screening, the generating the operating voltage based on the similarity calculation instructions includes: generating the operating voltage based on the similarity calculation type by using the data in the similarity calculation instructions.

When the similarity calculation type is the Jaccard similarity calculation, the generating the operating voltage based on the similarity calculation instructions includes: generating the operating voltage based on the similarity calculation type.

S1602: Select the to-be-calculated data based on the target address, and apply the operating voltage to the to-be-calculated data to perform similarity calculation, to generate an output signal.

S1603: Process the output signal and output a calculation result.

Different types of similarity calculation may be processed in different manners. For details, refer to related descriptions in the foregoing embodiments.

When the similarity calculation type is the Jaccard similarity calculation, the output signal includes a first signal output in a first clock cycle and a second signal output in a second clock cycle. The processing the output signal, and outputting the calculation result includes: comparing the first signal with a second reference current to obtain a first value, and delaying the first value for one clock cycle and outputting the first value; comparing the second signal with a third reference current to obtain a second value, and directly outputting the second value, where the second reference current is different from the third reference current; and performing division operation on the first value and the second value, and outputting the calculation result.

According to the similarity calculation method provided in this embodiment of this application, the similarity calculation can be implemented by applying the operating voltage to the selected to-be-calculated data. Therefore, data does not need to be frequently migrated. In comparison with a similarity calculation solution in a current technology, energy consumption of data migration can be reduced, and bandwidth between storage and computing can be saved.

Method or algorithm steps described in combination with the content disclosed in this application may be implemented by hardware, or may be implemented by a processor by executing software instructions. The software instructions may include a corresponding software module. The software module may be stored in a random access memory (random access memory, RAM), a flash memory, an erasable programmable read-only memory (erasable programmable ROM, EPROM), an electrically erasable programmable read-only memory (electrically EPROM, EEPROM), a register, a hard disk, a removable hard disk, a compact disc read-only memory (CD-ROM), or any other form of storage medium well-known in the art. For example, a storage medium is coupled to a processor, so that the processor can read information from the storage medium and write information into the storage medium. It is clear that the storage medium may be a component of the processor. The processor and the storage medium may be disposed in an ASIC. In addition, the ASIC may be located in a core network interface device. It is clear that the processor and the storage medium may exist in the core network interface device as discrete components.

A person skilled in the art should be aware that in the foregoing one or more examples, functions described in the present invention may be implemented by hardware, software, firmware, or any combination thereof. When the functions are implemented by the software, the functions may be stored in a computer-readable medium or transmitted as one or more instructions or code in a computer-readable medium. The computer-readable medium includes a computer storage medium and a communication medium, where the communication medium includes any medium that enables a computer program to be transmitted from one place to another. The storage medium may be any available medium accessible to a general-purpose or a dedicated computer.

The objectives, technical solutions, and beneficial effect of the present invention are further described in detail in the foregoing specific implementations. It should be understood that the foregoing descriptions are merely specific implementations of the present invention, but are not intended to limit the protection scope of the present invention. Any modification, equivalent replacement, or improvement made based on the technical solutions of the present invention shall fall within the protection scope of the present invention.

## Claims

1. A similarity calculation apparatus, wherein the similarity calculation apparatus comprises an input signal processing module, a data calculation module, and at least one output processing circuit, the input signal processing module is coupled to the at least one output processing circuit via the data calculation module, the data calculation module comprises a storage array, and the storage array is configured to store to-be-calculated data;
the input signal processing module is configured to: receive similarity calculation instructions, generate an operating voltage based on the similarity calculation instructions, and convert an address of the to-be-calculated data in the similarity calculation instructions into a target address;
the data calculation module is configured to: select, based on the target address, the to-be-calculated data stored in the storage array, and apply the operating voltage to the to-be-calculated data to perform similarity calculation; and
the at least one output processing circuit is configured to: process a signal output by the data calculation module, and output a calculation result.

2. The similarity calculation apparatus according to claim 1, wherein the similarity calculation instructions comprise a similarity calculation type, and the input signal processing module comprises a voltage encoding circuit, a first voltage conversion circuit, and an address decoding circuit;
the voltage encoding circuit is configured to generate the operating voltage based on the similarity calculation type;
the first voltage conversion circuit is configured to: directly transfer the operating voltage generated by the voltage encoding circuit to the data calculation module, or reverse the operating voltage generated by the voltage encoding circuit and then transfer the operating voltage to the data calculation module; and
the address decoding circuit is configured to convert the address of the to-be-calculated data in the similarity calculation instructions into the target address.

3. The similarity calculation apparatus according to claim 1 or 2, wherein the data calculation module further comprises a switch array, and the input signal processing module is coupled to the storage array via the switch array; and
the switch array is configured to select, based on the target address output by the address decoding circuit, a row and a column corresponding to the target address.

4. The similarity calculation apparatus according to any one of claims 1 to 3, wherein the at least one output processing circuit comprises a first output processing circuit, and the first output processing circuit comprises a transimpedance amplification circuit and at least one processing subcircuit;
the transimpedance amplification circuit is configured to convert the current signal output by the data calculation module into a voltage signal; and
the at least one processing subcircuit is configured to process and output an analog signal output by the transimpedance amplification circuit.

5. The similarity calculation apparatus according to claim 4, wherein the at least one processing subcircuit comprises a first processing subcircuit, the first processing subcircuit comprises an analog-to-digital conversion circuit, and the transimpedance amplification circuit is coupled to the analog-to-digital conversion circuit; and
the analog-to-digital conversion circuit is configured to convert the analog signal output by the transimpedance amplification circuit into a digital signal and output the digital signal.

6. The similarity calculation apparatus according to claim 4 or 5, wherein the at least one processing subcircuit further comprises a second processing subcircuit, the second processing subcircuit comprises a sense amplification circuit and a second voltage conversion circuit, and the transimpedance amplification circuit is coupled to the second voltage conversion circuit via the sense amplification circuit;
the sense amplification circuit is configured to compare the voltage signal output by the transimpedance amplification circuit with a reference voltage and output the voltage signal; and
the second voltage conversion circuit is configured to directly output the signal output by the sense amplification circuit or reverse the signal and then output the signal based on the similarity calculation type.

7. The similarity calculation apparatus according to claim 6, wherein when the similarity calculation type is exact search, the second voltage conversion circuit is configured to directly output the signal output by the sense amplification circuit; and when the similarity calculation type is fuzzy search, the second voltage conversion circuit is configured to reverse the signal output by the sense amplification circuit and then output the signal.

8. The similarity calculation apparatus according to any one of claims 5 to 7, wherein when the first output processing circuit comprises a plurality of processing subcircuits, the first output processing circuit further comprises a first selector; and
the first selector is configured to: output, to a corresponding processing subcircuit based on the similarity calculation type in the similarity calculation instructions, the analog signal output by the transimpedance amplification circuit.

9. The similarity calculation apparatus according to any one of claims 1 to 8, wherein the at least one output processing circuit further comprises a second output processing circuit, and the second output processing circuit comprises an analog-to-digital conversion circuit; and
the analog-to-digital conversion circuit is configured to convert an analog signal output by the data calculation module into a digital signal and output the digital signal.

10. The similarity calculation apparatus according to any one of claims 1 to 9, wherein the at least one output processing circuit further comprises a third output processing circuit, and the third output processing circuit comprises a sense amplification circuit; and
the sense amplification circuit is configured to compare the signal output by the data calculation module with a first reference current and output the signal.

11. The similarity calculation apparatus according to any one of claims 1 to 10, wherein the at least one output processing circuit further comprises a fourth output processing circuit, the fourth output processing circuit comprises a sense amplification circuit, a delay circuit, and a division circuit, an output end of the sense amplification circuit is separately coupled to an input end of the delay circuit and a first input end of the division circuit, and an output end of the delay circuit is coupled to a second input end of the division circuit.

12. The similarity calculation apparatus according to claim 11, wherein
the sense amplification circuit is configured to: compare a first signal output by the data calculation module in a first clock cycle with a second reference current to obtain a first value, and output the first value to the delay circuit; and compare a second signal output by the data calculation module in a second clock cycle with a third reference current to obtain a second value, and output the second value to the division circuit, wherein the second reference current is different from the third reference current;
the delay circuit is configured to delay the first value output by the sense amplification circuit and then output the first value to the division circuit; and
the division circuit is configured to perform division operation on the first value and the second value, and output a calculation result.

13. The similarity calculation apparatus according to claim 10, wherein the third output processing circuit further comprises a third selector, and the third selector is configured to: directly output the output signal of the sense amplification circuit or output the output signal of the sense amplification circuit to a calculation circuit based on the similarity calculation type in the similarity calculation instructions.

14. The similarity calculation apparatus according to claim 13, wherein the calculation circuit comprises a delay circuit and a division circuit, an output end of the third selector is separately coupled to an input end of the delay circuit and a first input end of the division circuit, and an output end of the delay circuit is coupled to a second input end of the division circuit;
the third selector is specifically configured to: when the similarity calculation type is Jaccard similarity calculation, output, to the delay circuit, a signal output by the sense amplification circuit in a first clock cycle, and output, to the division circuit, a signal output by the sense amplification circuit in a second clock cycle;
the delay circuit is configured to delay the signal output by the sense amplification circuit in the first clock cycle and then output the signal to the division circuit; and
the division circuit is configured to: perform division operation on the signal output by the sense amplification circuit in the first clock cycle and the signal output by the sense amplification circuit in the second clock cycle, and output a calculation result.

15. The similarity calculation apparatus according to any one of claims 1 to 14, wherein when the similarity calculation apparatus comprises a plurality of output processing circuits, the similarity calculation apparatus further comprises a second selector; and
the second selector is configured to: output, based on the similarity calculation type in the similarity calculation instructions, the signal output by the data calculation module to a corresponding output processing circuit.

16. The similarity calculation apparatus according to claim 15, wherein the similarity calculation type comprises at least one of Hamming distance calculation, the fuzzy search, the exact search, inner product similarity calculation, inner product similarity screening, or the Jaccard similarity calculation.

17. A similarity calculation method, wherein the method comprises:
generating an operating voltage based on similarity calculation instructions, and converting an address of to-be-calculated data in the similarity calculation instructions into a target address;
selecting the to-be-calculated data based on the target address, and applying the operating voltage to the to-be-calculated data to perform similarity calculation, to generate an output signal; and
processing the output signal and outputting a calculation result.

18. The method according to claim 17, wherein the similarity calculation instructions comprise a similarity calculation type, and the generating an operating voltage based on similarity calculation instructions comprises:
generating, based on the similarity calculation type, the operating voltage by using the data in the similarity calculation instructions.

19. The method according to claim 18, wherein the similarity calculation type comprises at least one of Hamming distance calculation, fuzzy search, exact search, inner product similarity calculation, or inner product similarity screening.

20. The method according to claim 17, wherein a similarity calculation type is Jaccard similarity calculation, the output signal comprises a first signal output in a first clock cycle and a second signal output in a second clock cycle, and the processing the output signal and outputting a calculation result comprises:
comparing the first signal with a second reference current to obtain a first value, and outputting the first value after a delay of one clock cycle; and comparing the second signal with a third reference current to obtain a second value, and directly outputting the second value, wherein the second reference current is different from the third reference current; and
performing division operation on the first value and the second value, and outputting the calculation result.

21. A storage device, wherein the storage device comprises a controller and the similarity calculation apparatus according to any one of claims 1 to 16, and the controller is configured to send similarity calculation instructions to the similarity calculation apparatus.

22. The storage device according to claim 21, wherein the storage device further comprises a storage module, and the storage module is configured to store to-be-calculated data and a calculation result.

23. The storage device according to claim 21 or 22, wherein the storage device is a hard disk or a memory.
